# EUROPEAN PATENT SPECIFICATION

(11) **EP 2 325 548 B1**
(45) Date of publication and mention of the grant of the patent: **27.03.2013**
(21) Application number: 10382301.9
(22) Date of filing: 16.11.2010
(51) Int. Cl.: F21S 9/03, F21S 11/00, F21V 33/00, G02B 6/00, H01L 31/042, F24J 2/06, F24J 2/08, F21V 8/00

(54) **Hybrid lighting device and lighting method**
Hybridbeleuchtungsvorrichtung und -beleuchtungsverfahren
Dispositif d'éclairage hybride et procédé d'éclairage

(30) Priority: 24.11.2009 ES 200931051
(43) Date of publication of application: 25.05.2011
(73) Proprietor: EIKA S.COOP., 48277 Etxebarria (ES)
(72) Inventor: Liébana Arribas, Iñaki, 48920 Portugalete (ES); Cayón Vázquez, David, 48960 Galdako (ES); Zubía Zaballa, Joseba Andoni, 48902 Barakaldo (ES); Pérez Rodríguez, Ana María, 48004 Bilbao (ES)
(74) Representative: Igartua, Ismael

(56) References cited:
- EP-A2- 2 196 744
- DE-A1- 10 319 928
- DE-U1- 29 823 351
- JP-A- 58 004 983
- JP-A- 2001 184 913
- US-A- 4 498 460
- US-A- 4 723 826
- US-A1- 2005 224 074

## Description

### TECHNICAL FIELD

This invention relates to a hybrid lighting device adapted to illuminate with sunlight and/or generate electric power, and to a lighting method implemented in a lighting system that comprises at least one hybrid lighting device.

### PRIOR ART

Lighting accounts for a large part of domestic energy consumption and results in unnecessary consumption throughout a large part of the day. Light control systems are becoming increasingly important as a result, particularly those combining sunlight or natural light with artificial light, energy-efficient buildings making use of natural light, and intelligent lighting systems such as presence detectors and natural-artificial light switches.

Document ES 2245405 B1 thus describes a photovoltaic lighting system in a dome structure that comprises a fixed structure, a skylight, tilting elements sensitive to solar radiation, and reflective tilting elements that each has a curved surface that adapts to the shape of the dome. The tilting elements sensitive to solar radiation may rotate on their axes, so that, during the course of the day, said elements are kept in a position that is substantially orthogonal to the solar radiation to ensure good photovoltaic use of the radiation. Additionally, the reflective tilting elements may rotate on their axes with the result that said elements are kept in a position so that, during the course of the day, they reflect the solar radiation towards the skylight in order to illuminate the internal space.

In addition document EP 2028511 A1 describes a solar and artificial hybrid lighting system in which the solar collector is arranged on the outside of a building and is adapted to collect solar power and transfer it by means of transfer means to the inside of the building. The hybrid system comprises a plurality of combined solar and artificial lights arranged inside the building and which are powered by natural light and additionally by artificial light as the day passes.

JP58004983A discloses a hybrid lighting device arranged to utilize sunray energy by combining a device which focuses sunrays, introduces them into a photoconductor cable and guides them to a section where illumination is requires and a device which receives sunrays and generates power. An assembled body is sealed into a transparent vessel, a solar cell being mounted outside the body and solar cells also outside beams condensed among the lenses.

### BRIEF DISCLOSURE OF THE INVENTION

The object of this invention is to provide a hybrid lighting device adapted to illuminate with sunlight and/or generate electric power, and a lighting method implemented in a lighting system that comprises the hybrid lighting device.

For this purpose the hybrid lighting device comprises at least one collector member that concentrates the sunlight or natural light, and sunlight transmission means suitable for feeding at least one lamp. The hybrid device comprises at least one hybrid module that includes the collector member arranged on a collector support a solar cell arranged on a panel, and the transmission means arranged coupled to the panel.

The panel and the collector support are movable in relation to each other, between a first position in which the natural light concentrated by each collector member falls on the solar cell, and a second position, in which the sunlight concentrated by each collector member falls on the transmission means.

An optimised hybrid lighting device is thus obtained, one that is compact and easy to maintain, capable of feeding at least one lamp with sunlight, thus providing considerable savings in electricity consumption and a reduction in the environmental impact. The solar power is used either to light rooms, that do not have openings at the front or which are underground, with natural light, or to generate electric power to feed the corresponding lamps or to return the electric power generated to the electric grid.

These and other advantages and characteristics of the invention will be made evident in the light of the drawings and the detailed description thereof.

### DESCRIPTION OF THE DRAWINGS

Figure 1 is a sectioned view in perspective of a hybrid lighting device according to the invention.
Figure 2 is a schematic view of the hybrid lighting device shown in Figure 1 in a first position.
Figure 3 is a schematic view of the hybrid lighting device shown in Figure 1 in a second position.
Figure 4 is a partial exploded view of the hybrid lighting device shown in Figure 1.
Figure 5 is a view in perspective of means of displacement of the hybrid lighting device shown in Figure1
Figure 6 is a view of a detail of the displacement means shown in Figure 5.
Figure 7 is a schematic view of a lighting system that comprises a hybrid lighting device shown in Figure 1.

### DETAILED DISCLOSURE OF THE INVENTION

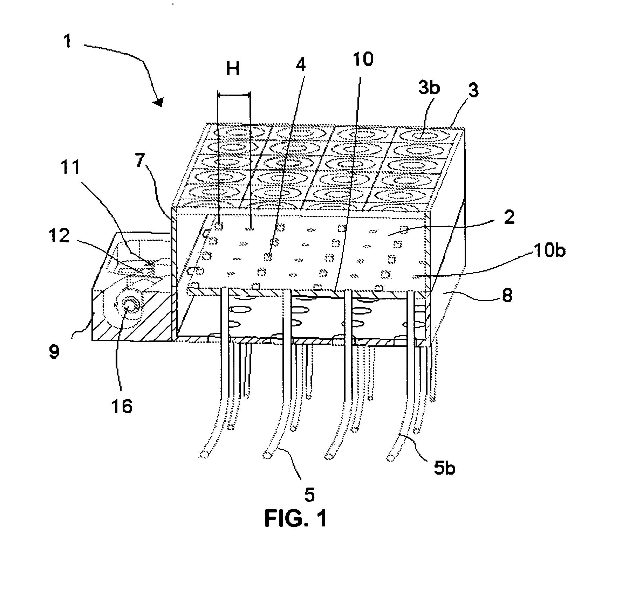

The hybrid lighting device 1, shown in Figure 1, according to the invention, is adapted to illuminate with sunlight, also known as natural light, and/or generate electric power that allows the interior of a compartment to be lit or returns the electric power to the electric grid.

The hybrid lighting device 1 comprises a plurality of hybrid modules 2, adjacent to each other, which concentrate the natural light to convert it into electric power or for lighting. Each hybrid module 2 comprises a collector member 3 arranged on a collector support 7, a semiconductor solar cell 4 fixed on a panel 10 arranged on the main support 8, and natural-light transmission means 5 coupled to the panel 10, the transmission means 5 being arranged separated from the solar cell 4 by a distance H.

The hybrid lighting device 1 also comprises a substantially rectangular main support 8 that provides rigidity to the hybrid lighting device 1 and on which are arranged the collector support 7 and panel 10 respectively. In other examples of the embodiment not shown in the figures, said collector support 7 and said main support 8 may be built into a single support.

In the embodiment shown in Figures 1 to 4, the transmission means 5 comprise a plastic fibre optic 5b, although in other embodiments they may include a reflective mirrored pipe made of a reflective material such as silver or aluminium.

In addition, the panel 10 is substantially flat, and is preferably made of metal, and includes holes 10b through which the corresponding fibre optic 5b is fixed to the panel 10. The collector member 3 mainly comprises a Fresnel lens 3b, although in other embodiments not shown in the figures, said collector member 3 may comprise a combination of lenses or another type of collector that is capable of concentrating the natural light in a certain point.

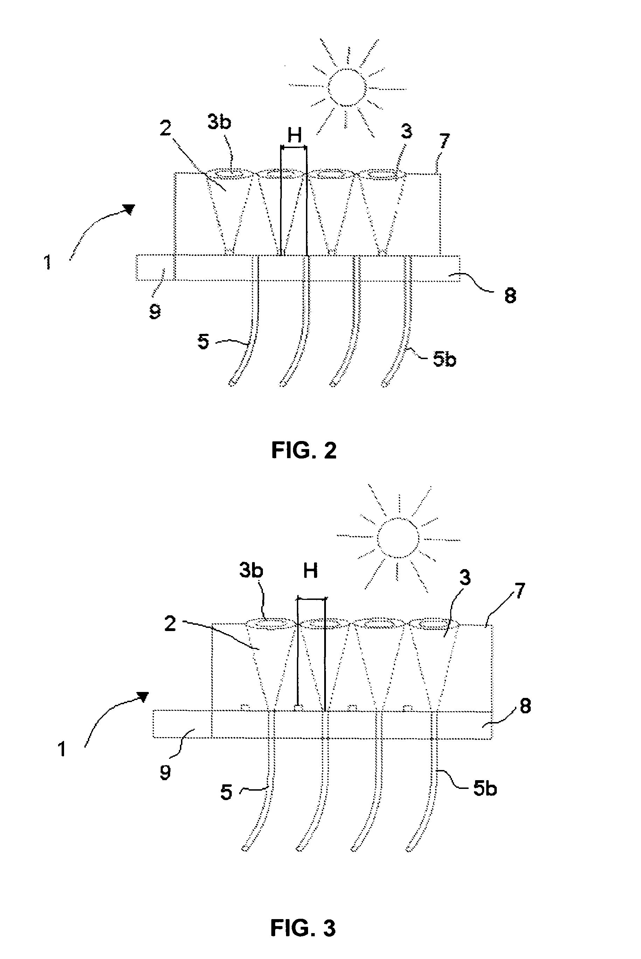

The hybrid lighting device 1 comprises displacement means 11 that move the panel 10 in relation to the collector support 7, and thus in relation to the main support 8, the distance H between a first position shown in Figure 2 and a second position, shown in Figure 3, said displacement being a linear displacement. As a result, the natural light concentrated by each Fresnel lens 3b falls on the corresponding solar cell 4 in the first position, and on the corresponding fibre optic 5b in the second position.

The main support 8 comprises grooves 8c in the back surface and through which pass the corresponding fibre optics 5b. The grooves 8c are sufficiently spacious to allow the free movement of the fibre optics 5b during the linear displacement of the panel 10.

In other embodiments not shown in the figures, the displacement means 11 may move the collector support 7 in relation to the panel 10, the panel 10 being fixed in this case.

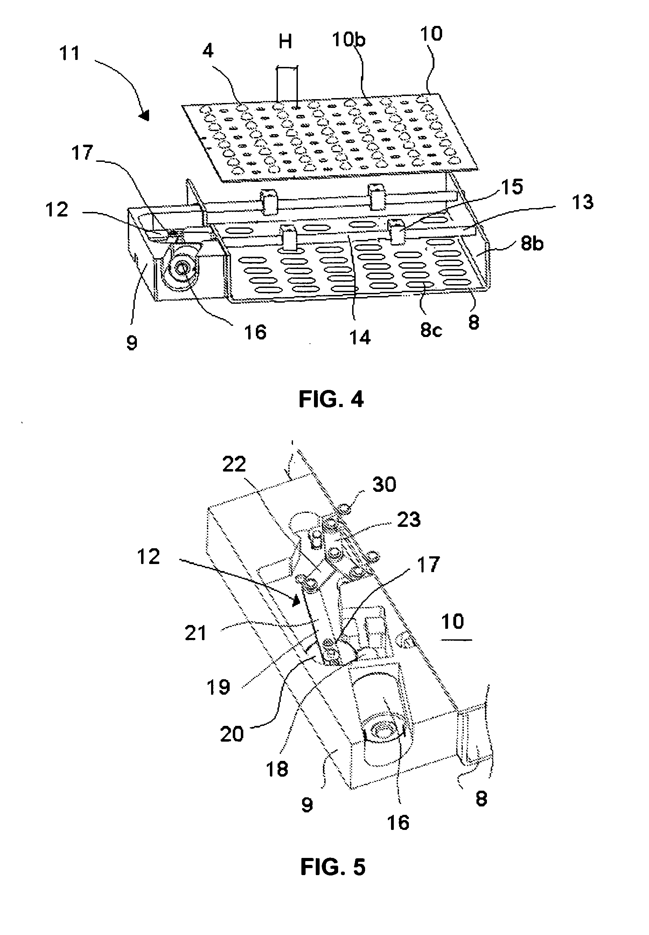

The displacement means 11, shown in detail in Figure 4, comprise means of activation 12 of the displacement, and guide means 13 that guide the relative movement between the panel 10 and the collector support 7 along the distance H. As a result, the guide means 13, shown in detail in Figure 4, comprise two substantially cylindrical guides 14, arranged substantially parallel to each other, aligned in the direction of displacement and fixed at the ends to side walls 8b of the main support 8, and at least one guide member 15 that moves along each guide 14. On one side the guide member 15 is passed through by the guide 14 and on the other it is fixed to the panel 10.

In other embodiments not shown in the figures, the guide means 13 may include a rail that acts as a linear guide, on which at least one runner fixed to the main support 8 moves.

The activation means 12, shown in detail in Figure 5, are arranged substantially housed in an auxiliary support 9 fixed laterally to the main support 8, said activation means 12 comprising a motor 16, preferably a DC motor, and mechanism of conversion 17 of the rotary movement of the motor 16 into a linear movement, the conversion mechanism 17 being arranged coupled to the motor 16 and fixed to the panel 10.

The conversion mechanism 17 thus comprises an endless screw 18 attached to the motor 16, a crown 20 attached to the endless screw 18 through which the speed of rotation is decreased and the output torque of the motor 16 is increased, and a crank connecting rod mechanism 19 attached to the crown 20. The crank connecting rod mechanism 19 includes a crank 21 attached to the crown 20, a main rod 22 connected to the crank 21, and a set of secondary rods 23 that have a substantially H-shaped arrangement and which connect the panel 10 to the main rod 22.

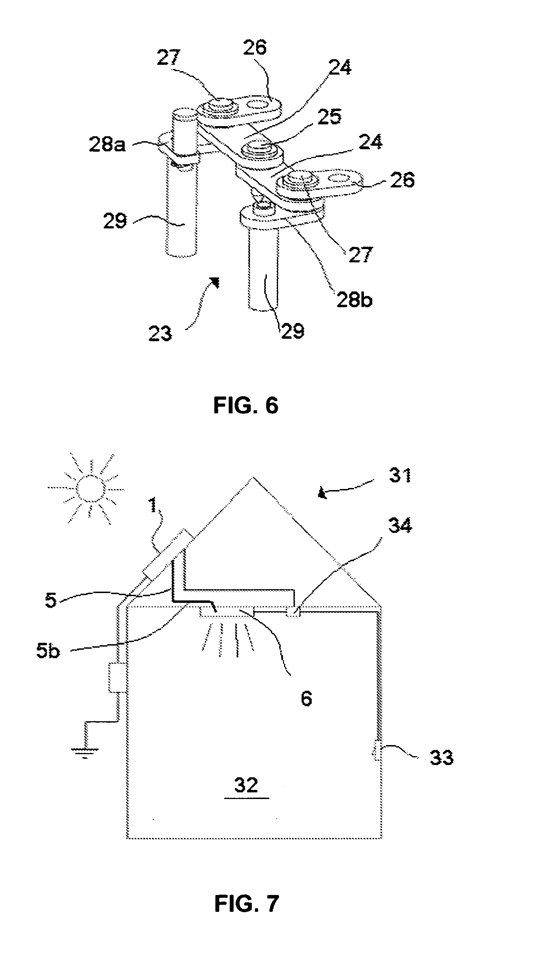

The set of secondary rods 23, shown in detail in Figure 6, comprises central rods 24 connected to each other and to the main rod 22 by means of a central articulated joint 25, and first side rods 26, each one of which is arranged connected at one end to the corresponding central rod 24 by means of a first lateral articulated joint and at the other end, to the panel 10 by means of a second lateral articulated joint 30. The set of secondary rods 23 also comprise a second side rod 28a that is substantially L-shaped and a third side rod 28b, each one of which, the second side rod 28a and third side rod 28b, is arranged connected at one end, to the corresponding central rod 24 and to the corresponding first side rod 26 by means of the lateral articulated joint 27, and at the other end, to the auxiliary structure 9 by means of a respective fixed articulated joint 29.

The mechanism of conversion 17 of the movement is a precise mechanism that is easy to assemble, as well as being a reversible mechanism, in other words the endless screw 18 may move the crown 20 on being activated by the motor 16, or the crown 20 may move the endless screw 18. In addition, as a set of secondary rods 23 is included, there is no need to include means for limiting the path travelled by the panel 10 in relation to the main support 8.

In other embodiments not shown in the figures, the rod-crank mechanism may include a set of secondary rods in a rhombus arrangement. In other examples, the conversion mechanism 17 may include a spindle that acts on the crank connecting rod mechanism 19 described above.

In other examples of the embodiment, the conversion mechanism 17 may include a set of gears fixed to the panel 10 and a rack fixed to the main support 8. In other embodiments, instead of a rack, a rod-crank mechanism 19 that includes a set of secondary rods 23 in a rhombus arrangement may be included.

The hybrid lighting device 1 may be built into a photovoltaic collector panel that includes a plurality of photovoltaic modules arranged adjacent to each other and around said hybrid lighting device 1.

Additionally, the lighting system 31 of the invention shown in Figure 7 comprises at least one hybrid lighting device 1 arranged on the outside of the compartment 32 or building to be lit, at least one lamp 6 arranged on the inside of the compartment 32 and capable of being feed with natural light and/or the electric power provided by the hybrid lighting device 1, and control/regulation means 34. When a user presses a switch 33 to switch on the corresponding lamp 6, the control/regulation system 34 acts on the means of displacement 11 of the hybrid lighting device 1, which move the panel 10 to the second position, in which the hybrid modules 3 are arranged centred in relation to the transmission means 5. In said second position, therefore, the natural light falls on the transmission means 5, which conduct said natural light to the corresponding lamp 6. On the occasions on which the natural light conducted to the lamp 6 is not sufficient to meet the lighting needs inside the compartment 32, the electrical grid to which the lamp 6 is connected in parallel supplies the necessary remaining power to obtain the necessary artificial light, which along with the natural light, illuminates the inside of the compartment 32, adapting itself to varying requirements throughout the day. To achieve this the lighting system 31 includes at least one sensor, not shown in the figures, that measures the level of light inside the compartment 32, and the control/regulation means 34, in accordance with the sensor measurement and the light requirements set down for said compartment 32, regulate the corresponding lamp 6 so that it generates more artificial light for the purpose of achieving ideal illumination according to the specifications laid down.

When the user presses the switch 33 to switch off the corresponding lamp 6, the control/regulation means 34 act on the displacement means 11, which displace the panel 10 to the first position, in which the corresponding hybrid modules 3 are arranged centred in relation to the corresponding solar cells 4. As a result, the natural light, in the event that it is daytime, falls on each solar cell 4, which convert said natural light into electric power, the hybrid lighting device acting as a photovoltaic panel. Said electric power that is generated may be stored for a subsequent use such as the supply of the light 6, or returned to the electric grid.

In addition, the hybrid lighting device 1 may include tracking means, not shown in the figures, that enable the displacement and the orientation of said lighting device 1 in relation to the sun throughout the day to obtain increased efficiency in the concentration of sunlight.

## Claims

1. Hybrid lighting device arranged to illuminate with sunlight and/or generate electric power, which comprises at least one collector member (3) that concentrates the sunlight, means of transmission (5) of said sunlight suitable for supplying at least one light (6), at least one hybrid module (2) that includes the collector member (3) arranged on a collector support (7), and a solar cell (4) arranged on a panel (10), **characterised in that** said transmission means (5) are arranged coupled to the panel (10), the panel (10) and the collector support (7) being movable in relation to each other between a first position, in which the sunlight concentrated by each collector member (3) falls on the solar cell (4) and a second position, in which the sunlight concentrated by each collector member (3) falls on the transmission means (5).

2. Hybrid lighting device according to the preceding claim, wherein the relative displacement between the panel (10) and the collector support (7) is a linear displacement.

3. Hybrid lighting device according to any of the preceding claims, wherein the panel (10) moves in relation to the collector support (7) that is arranged fixed.

4. Hybrid lighting device according to any of the preceding claims, wherein the transmission means (5) comprise a plastic fibre optic (5b).

5. Hybrid lighting device according to any of the preceding claims, wherein the displacement means (11) comprise means of activation (12) of the displacement, and guide means (13) that guide the relative displacement between the panel (10) and the collector support (7).

6. Hybrid lighting device according to claim 5, wherein the guide means (13) comprise at least one guide (14) fixed to a main support (8), and at least one guide member (15) fixed to the panel (10) and coupled to the guide (14) in a movable manner in relation to said guide (14).

7. Hybrid lighting device according to claim 6, wherein the guide (14) is cylindrical.

8. Hybrid lighting device according to either of claims 6 or 7, wherein the guide means (13) comprise two guides (14) arranged substantially parallel to each other.

9. Hybrid lighting device according to any of claims 5 to 8, wherein the activation means (12) comprise a motor (16) housed in an auxiliary support (9) and a mechanism of conversion (17) of the rotary movement of the motor (16) into a linear movement, arranged coupled to the motor (16) and to the panel (10).

10. Hybrid lighting device according to claim 9, wherein the conversion mechanism (17) comprises an endless screw (18) attached to the motor (16), a crown (20) attached to the motor (16), and a crank connecting rod mechanism (19) attached to the crown (20) and fixed to the corresponding panel (10).

11. Hybrid lighting device according to claim 10, wherein the crank connecting rod mechanism (19) comprises a crank (21) attached to the crown (20), a main rod (22) connected to the crank (21), and a set of secondary rods (23) that connect the panel (10) to the main rod (22).

12. Hybrid lighting device according to claim 11, wherein the set of secondary rods (23) comprises central rods (24) connected to each other and to the main rod (22), first side rods (26) each one of which is arranged connected to the corresponding central rod (24) and to the panel (10), and second side rods (28), each one of which is arranged connected to the corresponding central rod (24) and to the corresponding first side rod (26).

13. Hybrid lighting device according to any of the preceding claims, wherein the collector member (3) comprises a Fresnel lens.

14. Lighting system that comprises at least one hybrid lighting device (1) according to any of the preceding claims.

15. Lighting method implemented in a lighting system according to the preceding claim, wherein, when the user switches on the lamp (6), the corresponding collector member (3) is displaced by the displacement means (11) to the second position, being arranged centred on the corresponding transmission means (5), and when the user switches off the lamp (6), the corresponding collector member (3) returns to the first position, being arranged centred on the solar cell (4).

## Patentansprüche

1. Hybride Beleuchtungsvorrichtung, die zur Beleuchtung mit Sonnenlicht und/oder zur Erzeugung elektrischen Stroms angeordnet ist, umfassend mindstens ein Sammelelement (3), das das Sonnenlicht konzentriert, zur Versorgung mindestens einer Lampe (6) geeignete Mittel zur Übertragung (5) des Sonnenlichts, mindestens ein das auf einem Sammlerträger (7) angeordnete Sammelelement (3) umfassendes hybrides Modul (2) sowie eine auf einer Platte (10) angeordnete Photovoltaikzelle (4), dadurch charakterisiert, dass die Übertragungsmittel (5) an die Platte (10) gekoppelt sind, wobei die Platte (10) und der Sammlerträger (7) relativ zueinander zwischen einer ersten Position, in der das von jedem Sammelelement (3) konzentrierte Sonnenlicht auf die Photovoltaikzelle (4) fällt, und einer zweiten Position, in der das von jedem Sammelelement (3) konzentrierte Sonnenlicht auf die Übertragungsmittel (5) bewegbar sind.

2. Hybride Beleuchtungsvorrichtung nach dem vorstehenden Anspruch, wobei die relative Verschiebung zwischen der Platte (10) und dem Sammlerträger (7) eine lineare Verschiebung ist.

3. Hybride Beleuchtungsvorrichtung nach einem der vorstehenden Ansprüche, wobei sich die Platte (10) relativ zum ortsfest angeordneten Sammlerträger (7) bewegt.

4. Hybride Beleuchtungsvorrichtung nach einem der vorstehenden Ansprüche, wobei die Übertragungsmittel (5) einen LWL auf Kunststoffbasis (5b) umfassen.

5. Hybride Beleuchtungsvorrichtung nach einem der vorstehenden Ansprüche, wobei die Verschiebungsmittel (11) Mittel (12) zur Aktivierung der Verschiebung sowie Führungsmittel (13), die die relative Verschiebung zwischen der Platte (10) und dem Sammlerträger (7) leiten, umfassen.

6. Hybride Beleuchtungsvorrichtung nach Anspruch 5, wobei die Führungsmittel (13) mindestens eine auf einem Hauptträger (8) fixierte Führung (14) sowie mindestens ein auf der Platte (10) fixiertes und an die Führung (14) relativ zur Führung (14) beweglich gekoppeltes Führungselement (15) umfassen.

7. Hybride Beleuchtungsvorrichtung nach Anspruch 6, wobei die Führung (14) zylindrisch ist.

8. Hybride Beleuchtungsvorrichtung nach einem der Ansprüche 6 oder 7, wobei die Führungsmittel (13) zwei Führungen (14) umfassen, die im Wesentlichen parallel zueinander angeordnet sind.

9. Hybride Beleuchtungsvorrichtung nach einem der Ansprüche 5 bis 8, wobei die Aktivierungsmittel (12) einen in einem Hilfsträger (9) angeordneten Motor (16) und einen an den Motor (16) und die Platte (10) gekoppelten Mechanismus (17) zur Umwandlung der rotatorischen Bewegung des Motors (16) in eine lineare Bewegung umfassen.

10. Hybride Beleuchtungsvorrichtung nach Anspruch 9, wobei der Umwandlungsmechanismus (17) eine an den Motor (16) gebundene Schnecke (18),einen an den Motor (16) gebundenen Lagerdeckel (20) sowie einen an den Lagerdeckel (20) gebundenen und auf der entsprechenden Platte (10) fixierten Kurbelstangenmechanismus (19) umfasst.

11. Hybride Beleuchtungsvorrichtung nach Anspruch 10, wobei der Kurbelstangenmechanismus (19) eine an den Lagerdeckel (20) gebundene Kurbel (21), eine mit der Kurbel (21) verbundene Hauptstange (22) sowie eine Gruppe Hilfsstangen (23), die die Platte (10) mit der Hauptstange (22) verbinden, umfasst.

12. Hybride Beleuchtungsvorrichtung nach Anspruch 11, wobei die Gruppe Hilfsstangen (23) miteinander und mit der Hauptstange (22) verbundene Zentralstangen (24), jeweils mit der entsprechenden Zentralstange (24) und der Platte (10) verbundene erste Seitenstangen (26) sowie jeweils mit der entsprechenden Zentralstange (24) und der entsprechenden ersten Seitenstange (26) verbundene zweite Seitenstangen (28) umfasst.

13. Hybride Beleuchtungsvorrichtung nach einem der vorstehenden Ansprüche, wobei das Sammelelement (3) eine Fresnellinse umfasst.

14. Beleuchtungsanlage, umfassend mindestens eine hybride Beleuchtungsvorrichtung (1) nach einem der vorstehenden Ansprüche.

15. In einer Beleuchtungsanlage nach dem vorstehenden Anspruch ausgeführtes Beleuchtungsverfahren, wobei, wenn die Bedienperson die Lampe (6) einschaltet, das entsprechende Sammelelement (3) von den Verschiebungsmitteln (11) in die zweite Position verschoben wird, und auf dem entsprechenden Übertragungsmittel (5) zentriert angeordnet ist, und, wenn die Bedienperson die Lampe (6) ausschaltet, das entsprechende Sammelelement (3) in die erste Position zurückkehrt und auf der Photovoltaikzelle (4) zentriert angeordnet ist.

## Revendications

1. Dispositif d'éclairage hybride prévu pour éclairer avec les rayons du soleil et/ou pour générer une énergie électrique, qui comprend au moins un élément de collecte (3) qui concentre les rayons du soleil, un moyen de transmission (5) desdits rayons du soleil capable de fournir au moins une lumière (6), au moins un module hybride (2) qui comprend ledit élément de collecte (3) placé sur un support de collecteur (7), et une pile solaire (4) placée sur un panneau (10), **caractérisé en ce que** ledit moyen de transmission (5) est relié audit panneau (10), ledit panneau (10) et ledit support de collecteur (7) pouvant se déplacer l'un par rapport à l'autre entre une première position dans laquelle les rayons du soleil concentrés par chaque élément de collecte (3) heurtent ladite pile solaire (4), et une seconde position dans laquelle les rayons du soleil concentrés par chaque élément de collecte (3) heurtent ledit moyen de transmission (5).

2. Dispositif d'éclairage hybride selon la revendication précédente, dans lequel le déplacement relatif entre ledit panneau (10) et ledit support de collecteur (7) est un déplacement linéaire.

3. Dispositif d'éclairage hybride selon l'une quelconque des revendications précédentes, dans lequel ledit panneau (10) se déplace par rapport audit support de collecteur (7) qui est fixe.

4. Dispositif d'éclairage hybride selon l'une quelconque des revendications précédentes, dans lequel ledit moyen de transmission (5) comprend une fibre optique en plastique (5b).

5. Dispositif d'éclairage hybride selon l'une quelconque des revendications précédentes, dans lequel ledit moyen de déplacement (11) comprend un moyen d'activation (12) du déplacement, et un moyen de guidage (13) qui guide le déplacement relatif entre ledit panneau (10) et ledit support de collecteur (7).

6. Dispositif d'éclairage hybride selon la revendication 5, dans lequel ledit moyen de guidage (13) comprend au moins un guide (14) fixé sur un support principal (8), et au moins un élément de guidage (15) fixé sur ledit panneau (10) et relié audit guide (14) de manière mobile par rapport audit guide (14).

7. Dispositif d'éclairage hybride selon la revendication 6, dans lequel ledit guide (14) est cylindrique.

8. Dispositif d'éclairage hybride selon l'une des revendications 6 ou 7, dans lequel ledit moyen de guidage (13) comprend deux guides (14) placés de manière sensiblement parallèle l'un par rapport à l'autre.

9. Dispositif d'éclairage hybride selon l'une quelconque des revendications 5 à 8, dans lequel ledit moyen d'activation (12) comprend un moteur (16) placé dans un support auxiliaire (9) et un mécanisme de conversion (17) du mouvement de rotation dudit moteur (16) en mouvement linéaire, relié audit moteur (16) et audit panneau (10).

10. Dispositif d'éclairage hybride selon la revendication 9, dans lequel ledit mécanisme de conversion (17) comprend une vis sans fin (18) reliée audit moteur (16), une couronne (20) reliée audit moteur (16), et un mécanisme de manivelle de commande (19) reliée à ladite couronne (20) et fixé sur le panneau correspondant (10).

11. Dispositif d'éclairage hybride selon la revendication 10, dans lequel ledit mécanisme de manivelle de commande (19) comprend une manivelle (21) reliée à ladite couronne (20), une tige principale (22) reliée à ladite manivelle (21), et un ensemble de tiges secondaires (23) qui relient ledit panneau (10) à ladite tige principale (22).

12. Dispositif d'éclairage hybride selon la revendication 11, dans lequel ledit ensemble de tiges secondaires (23) comprend des tiges centrales (24) reliées les unes aux autres et à ladite tige principale (22), des premières tiges latérales (26) dont chacune est reliée à la tige centrale correspondante (24) et audit panneau (10), et des secondes tiges latérales (28), dont chacune est reliée à la tige centrale correspondante (24) et à la première tige latérale correspondante (26).

13. Dispositif d'éclairage hybride selon l'une quelconque des revendications précédentes, dans lequel ledit élément de collecte (3) comprend une lentille de Fresnel.

14. Dispositif d'éclairage qui comprend au moins un dispositif d'éclairage hybride (1) selon l'une quelconque des revendications précédentes.

15. Procédé d'éclairage appliqué dans un système d'éclairage selon la revendication précédente, dans lequel, lorsque l'utilisateur allume la lampe (6), l'élément de collecte correspondant (3) est déplacé par ledit moyen de déplacement (11) dans ladite seconde position, en étant centré sur le moyen de transmission correspondant (5), et, lorsque l'utilisateur éteint la lampe (6), l'élément de collecte correspondant (3) revient dans ladite première position, en étant centré sur ladite pile solaire (4).
